(19) Europäisches Patentamt / European Patent Office / Office européen des brevets

(11) **EP 1 921 015 B1**

(12) **EUROPEAN PATENT SPECIFICATION**

(45) Date of publication and mention
of the grant of the patent:
**30.09.2015 Bulletin 2015/40**

(51) Int Cl.:
**C23C 16/04** (2006.01)      **C23C 16/30** (2006.01)
**C23C 16/40** (2006.01)

(21) Application number: **06782821.0**

(22) Date of filing: **18.08.2006**

(86) International application number:
**PCT/JP2006/316262**

(87) International publication number:
**WO 2007/026554 (08.03.2007 Gazette 2007/10)**

(54) **SYNTHETIC RESIN CONTAINER WITH HIGH BARRIER CAPABILITY**

KUNSTHARZBEHÄLTER MIT HOHEM SPERRVERMÖGEN

RÉCIPIENT EN RÉSINE SYNTHÉTIQUE AYANT UNE GRANDE CAPACITÉ DE BARRIÈRE

(84) Designated Contracting States:
**DE FR GB**

(30) Priority: **31.08.2005 JP 2005251057**

(43) Date of publication of application:
**14.05.2008 Bulletin 2008/20**

(73) Proprietor: **Yoshino Kogyosho Co., Ltd.
Tokyo 136-8531 (JP)**

(72) Inventors:
• **TAKADA, Makoto
Matsudo-shi, Chiba
270-2297 (JP)**
• **INABA, Junichi
Tokyo
136-8531 (JP)**

• **SUZUKI, Masato
Isehara-shi, Kanagawa
259-1103 (JP)**

(74) Representative: **Gray, James et al
Withers & Rogers LLP
4 More London Riverside
London SE1 2AU (GB)**

(56) References cited:
**EP-A1- 1 561 840      EP-A1- 1 852 522
WO-A1-2004/087989   JP-A- 2000 079 944
JP-A- 2004 300 479    JP-A- 2005 089 859
US-A1- 2003 044 552**

**Description**

TECHNICAL FIELD

The present invention relates to synthetic resin containers having a barrier film with a high barrier property formed at least on an inner surface and outer surface of a container body, and particularly relates to a container intended to improve a vapor barrier property while maintaining a high gas barrier property such as a high oxygen barrier property.

RELATED ART

A synthetic resin container represented by a bottle made of polyethylene terephthalate (PET), i.e., represented by a so-called PET bottle has expanded its application to soft drinks, alcohol beverages, edible oils, soy sauces and the like, along with its widespread use. It is common for these containers that a film containing a silicon oxide (SiOx) compound which has a high gas barrier property is formed on a container body from the aspect of maintaining the quality of contents since synthetic resins such as PET have a nature of permeating gas such as oxygen gas and carbon dioxide gas.

However, the synthetic resins such as PET resin also have a permeability to moisture such as a vapor, so that a conventional bottle with a film of a silicon oxide compound has a high gas barrier property but has a less improved effect on a moisture barrier property (hereinafter referred to as a "vapor barrier property"), which may be insufficient for some content to maintain its quality.

In this connection, it is proposed in, for example, JP 2004-168325 A that a silicon oxide compound film containing carbon is formed on a conventional container by using an organic silicon oxide and a inert gas and an ratio of elements in the silicon oxide compound containing carbon is defined, thereby preventing a degradation of the film and a decrease of adhesiveness to the resin.

WO 2004/087989 discloses a container body coated with a barrier film with an organic silicon compound film formed between the container surface and the barrier film.

DISCLOSURE OF THE INVENTION

The present inventor, however, has been studied and founded that an improvement of a gas barrier property for oxygen is not necessarily correlate with an improvement of a vapor barrier property. As a result, the present inventor has reached to recognize that when not both but either one of the barrier properties is taken into consideration, as is the case of the above-mentioned conventional container, to define the ratio of elements in the organic silicon compounds, a vapor barrier property, on one hand, may be improved, but on the other hand, a gas barrier property which is an intended purpose, may not be effectively exerted.

It is an object of the present invention to provide, in a simple manner, a synthetic resin container which improves a vapor barrier property while maintaining a gas barrier property against oxygen or the like at a high level.

According to the present invention, there is provided a synthetic resin container possessing a higher barrier property, characterized in that at least one barrier film is formed on at least one of inner and outer surfaces of a container body by a plasma CVD method with organic silicon compound gas and oxygen gas as raw materials, the barrier film containing silicon oxide in which a compositional ratio of oxygen among silicon, oxygen and carbon is not less than 50 atom% and a compositional ratio of carbon among silicon, oxygen and carbon is not less than 3 atom% and not more than 20 atom% and in that an organic silicon compound film having the compositional ratio of oxygen of less than 20 atom% among silicon, oxygen and carbon is formed on a position opposed to the container surface across the barrier film, the organic silicon compound film being formed by a plasma CVD with an organic silicon compound gas and oxygen gas as raw materials.

In the present invention, the compositional ratio of carbon in the barrier film is preferably not more than 8 atom%. Further, in the present invention, an organic silicon compound film having the compositional ratio of oxygen of less than 20 atom% is preferably formed on a position opposed to the container surface across the barrier film by a plasma CVD with an organic silicon compound gas and oxygen gas as raw materials.

A synthetic resin container having a improved vapor barrier property while maintaining a high gas barrier property may thus be provided.

In the present invention, when the compositional ratio of carbon is not more than 8 atom%, a higher vapor barrier property may be obtained while maintaining a gas barrier property at a higher level.

Also in the present invention, when an organic silicon compound film having the compositional ratio of oxygen of less than 50 atom% is preferably formed on at least one of a place between the container surface and the barrier film and a place opposed to the container surface across the barrier film by a plasma CVD with an organic silicon compound gas and oxygen gas as raw materials, it is possible to prevent an occurrence of a crack during the formation of the barrier film to further improve the gas and vapor barrier properties. This is because the organic silicon compound film is relatively soft as compared with the relatively hard barrier film, has little gas barrier property, and a certain vapor barrier property.

BRIEF DESCRIPTION OF THE DRAWINGS

[FIG. 1] FIG. 1 is an enlarged sectional view of an exemplary PET bottle.
[FIG. 2] FIG. 2 is an enlarged sectional view of an essential part of a PET bottle according to a first embodiment of the present invention.
[FIG. 3] FIG. 3 is an enlarged sectional view of an essential part of a PET bottle according to a second embodiment of the present invention.

REFERENCE SYMBOLS

1 wall portion
2 barrier film
3(3a, 3b): organic silicon compound film

BEST MODE FOR CARRYING OUT THE INVENTION

In the next, the present invention is discussed in detail with reference to the drawings.

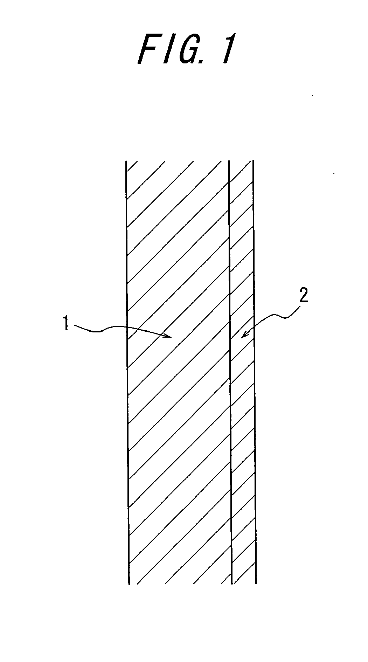

FIG. 1 is an enlarged sectional view of an exemplary container, which bottle is represented by a bottle made of polyethylene terephthalate (herein after referred to as a "PET bottle" molded by biaxial-stretching blow molding. In the figure, the reference numeral 1 designates a wall portion constituting a bottle body, and the reference numeral 2 designates a coating film with a high barrier property which is provided on an inner surface of the wall portion 1 to prevent permeation of gas (such as oxygen gas or carbon dioxide gas) or vapor through the bottle from the interior to the exterior or vice versa.

The coating film 2 is a barrier film consisting of silicon oxide and disposed adjacent to the wall portion 1. The barrier film 2 is composed of a compound including at least silicon Si, carbon C, hydrogen H and oxygen O.

The barrier film 2 is formed by plasma CVD utilizing a power source such as a high-frequency power source or a microwave power source (magnetron). A pulse discharge condition in the plasma CVD is; On: 0.1 sec. and Off: 0.1 sec.

Specifically, the barrier film 2 constituting mainly of silicon oxide in which a compositional ratio of oxygen O among silicon S, oxygen O and carbon C is not less than 50 atom% and a compositional ratio of carbon C among silicon S, oxygen O and carbon C is not less than 3 atom% and not more than 20 atom% is formed on the inner surface of the container body 1 by a plasma CVD method with an organic silicon compound gas such as hexamethyldisiloxane (HMDSO) or hexamethyldisilazane (HMDSN) and oxygen gas (O2) as raw materials. In this case, inert gas (such as argon (Ar) gas) or nitrogen (N) gas may be added, but it is preferred to use only two kinds of gases, i.e., organic silicon compound gas and oxygen gas are used since the film-forming equipment may be simplified to thereby easily control the compositional ratio at a suitable range.

In this connection, a barrier property against vapor (vapor barrier property) should be taken into consideration along with the gas barrier property against oxygen gas, carbon dioxide and the like in order to maintain the quality of the contents in the container made of synthetic resin such as PET resin.

To this end, there exists the following relationship between the compositional ratios (atom%) of oxygen (O) and carbon C and barrier improvement factor BIF at least in the barrier film 2.

It is noted that the barrier improvement factor BIF refers to a ratio of the amount of the gas (vapor) permeation of the coated bottle of which the barrier film 2 is formed on the surface to the amount of the gas (vapor) permeation of the uncoated bottle of which the barrier film 2 is not formed on the surface, and is expressed as:

$$\mathrm{BIF} = (\text{amount of gas (vapour) permeation of uncoated bottle})/(\text{amount of gas (vapour) permeation of coated bottle}) \quad \cdots(1)$$

When the compositional ratio (atom%) of carbon C in the barrier film 2 is not less than 3%, vapor barrier improvement factor BIF is not les than 2, which enable the vapor barrier property to be sufficiently suitable for use. Consequently, if the compositional ratio of carbon C is increased, the vapor barrier property is also improved along with the increase of the compositional ratio of carbon C, but, in terms of the gas barrier property, although it is maintained at high level, it tends to be decreased along with the increase of the compositional ratio of carbon C.

Accordingly, when compositional ration of carbon in the barrier film 2 is suppressed to not more than 20 atom%, oxygen gas barrier improvement factor BIF is not less than 5, so that a higher vapor barrier property can be obtained while a gas barrier property is maintained at a high level.

That is, when the barrier film 2 comprising a silicon oxide in which compositional ratio of oxygen O is not less than 50 atom% is formed by a plasma CVD method with organic silicon compound gas and oxygen gas as raw materials, compositional ratio of carbon C not less than 3 atom% and not more than 20 atom% may improve a vapor barrier property while ensuring a high gas barrier property.

Thus, according to the present example, it is possible to provide, in a simple manner, a PET bottle which improves the vapor barrier property while maintaining the gas barrier property at a high level.

Additionally, in the present example, compositional ratio of carbon in the barrier film 2 may be not less than 3 atom% and not more than 20 atom%. Particularly, when the compositional ratio of carbon is not more than 8 atom %, oxygen gas barrier improvement factor is not less than 8.5, so that a higher vapor barrier property can be obtained while the oxygen gas barrier property is maintained at a even higher level. It is noted that in the present invention the barrier film 2 has an angle of contact with water within a range of 40° to 60°. The angle (°) of contact refers to a angle of contact of the barrier film 2 with water.

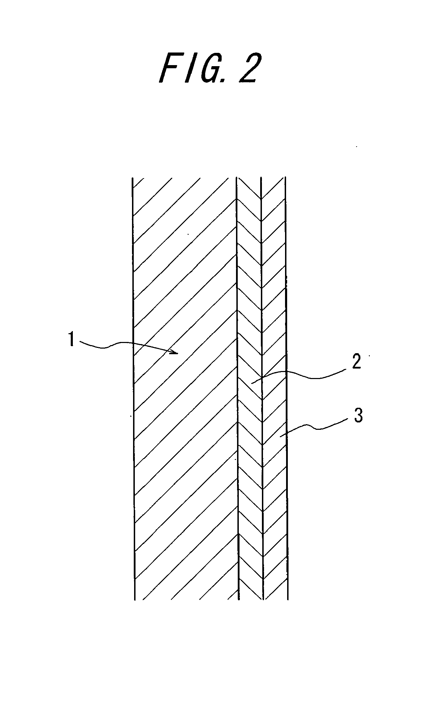

FIG. 2 illustrates an enlarged sectional view of an essential part of a first embodiment of the present invention. Note that the same elements as in the aforementioned example are denoted by the same reference numerals and descriptions thereof are omitted.

In FIG. 2, the reference numeral 3 denotes an organic silicon compound film formed on a surface of the barrier film 2. The organic silicon compound film 3 is formed in the same manner as the barrier film 2 by a plasma CVD method with organic silicon compound gas (for example, HMDSO gas) and oxygen gas as raw materials, is an organic silicon compound film in which compositional ratio of oxygen O among silicon Si, oxygen O and carbon C is less than 50 atom%. In this case, as mentioned above, it is preferred to use only organic silicon compound gas and oxygen gas to form the barrier film 2, since the film-forming equipment may be simplified to thereby easily control the compositional ratio at a suitable range.

With such a configuration, the organic silicon compound film 3 is relatively soft as compared with the relatively hard barrier film and has little gas barrier property, so that the gas barrier property and vapor barrier property can be improved more than that of the aforementioned example which has the single layer film without the organic silicon compound film 3 and that the barrier film 2 can be protected from an impact or the like. It is noted that the barrier film 2 and the organic silicon compound film 3 may be mutually interchangeable in terms of their layer configurations (arrangements).

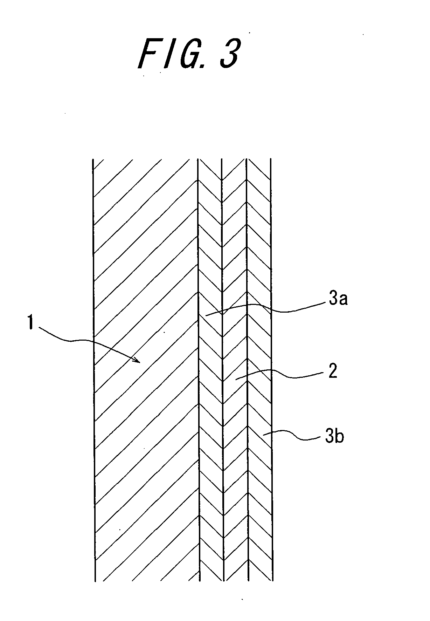

FIG. 3 is an enlarged sectional view of an essential part of a second embodiment of the present invention. The present embodiment is a variation of the first embodiment shown in FIG. 2, and the same elements as in the first embodiment is designated by the same reference numerals and their descriptions are omitted.

In the present embodiment, organic silicon compound films 3a, 3b in which compositional ratio of oxygen O among silicon Si, oxygen O and carbon C is not more than 20 atom% are formed in the same manner as in the first embodiment at least one of a position between the inner surface of the wall portion 1 and the barrier film 2, i.e., between the inner surface of the wall portion 1 and the barrier film 2 and a position opposed to the surface of the wall portion 1 across the barrier film 2 by a plasma CVD method with organic silicon compound gas (for example, HMDSO gas) and oxygen gas as raw materials.

With such a configuration, the organic silicon compound films 3a, 3b are relatively soft as compared with the both surfaces of the relatively hard barrier film and have little gas barrier property, so that the gas barrier property and vapor barrier property can be improved even more than that of the first embodiment in which the organic silicon compound film 3 is provided only on one surface of the barrier film and that the barrier film 2 can be protected from an impact or the like.

Further, although the organic silicon compound films 3a, 3b are provided on at least one of a position between the surface of the wall portion 1 and the barrier film 2 and at a position opposed to the surface of the wall portion 1 across the barrier film 2 in the present embodiment, the films may be provided on at least one of these positions as can be apparent from the first embodiment or the like.

Furthermore, compositional ratio of oxygen O in the organic silicon compound film 3 or 3a, 3b may remain the same over the thickness of the film, or may gradually increase along with the increase of the distance from the container body (wall portion 1).

In the above-mentioned embodiments, the barrier film 2 is provided on the inner surface of the wall portion 1 constituting the container body, but it may be provided on the outer surface of the wall portion 1. In addition, the barrier film 2 is explained as a single layer, but it may be multiple layers.

EXAMPLE

A barrier film 2 is formed on an inner surface of a wall portion 1 of a PET bottle by a plasma CVD method using high frequency pulses with HMDSO gas and oxygen gas being added as raw materials. A gas barrier property and a vapor barrier property are evaluated for the bottle.

For the evaluations of the gas barrier and vapor barrier properties, barrier improvement factor BIF calculated from the above-described formula (1) is used, and compositional ratio of elements is measured by X-ray photoelectron spectroscopy (XPS, ESCA). Oxygen permeability is measured by OXTRAN manufactured by MOCON Inc. Vapor permeability is measured in compliance with a method of vapor permeability test specified by JIS Z 0222.

Conventional Example 1 is according to the conventional technique and has oxygen and carbon compositional ratios in the barrier film 2 of 65 atom% and 1 atom%, respectively. In this case, the gas barrier improvement factor BIF is calculated from the above-mentioned formula (1) to give BIF =15.2 for oxygen permeability while the vapor barrier improvement factor is calculated from the above-mentioned formula (1) to give BIF = 1.7 for vapor permeability.

In contrast, Example 1 has oxygen and carbon compositional ratios in the barrier film 2 of 61 atom% and 8 atom%, respectively. In this case, the gas barrier improvement factor BIF is calculated from the above-mentioned formula (1) to give BIF = 8.8 for oxygen permeability while the vapor barrier improvement factor is calculated from the above-mentioned formula (1) to give BIF = 4.6 for vapor permeability.

In contrast, Example 2 has oxygen and carbon compositional ratios in the barrier film 2 of 53 atom% and 19 atom%, respectively. In this case, the gas barrier improvement factor BIF is calculated from the above-mentioned formula (1) to give BIF = 5.4 for oxygen permeability while the vapor barrier improvement factor is calculated from the above-mentioned formula (1) to give BIF =10.1 for vapor permeability.

Referring to Examples 1 and 2, it is confirmed that a contact angle θ of the barrier film 2 with water is within a range of 40 deg to 60 deg.

INDUSTRIAL APPLICABILITY

A container of the present invention may be applicable to a not only bottle but also a wide-mouth jar as far as the container has a mouth portion.

**Claims**

1. A synthetic resin container possessing a higher barrier property, **characterized in that** at least one barrier film is formed on at least one of inner and outer surfaces of a container body by a plasma CVD method with organic silicon compound gas and oxygen gas as raw materials, the barrier film containing silicon oxide in which a compositional ratio of oxygen among silicon, oxygen and carbon is not less than 50 atom% and a compositional ratio of carbon among silicon, oxygen and carbon is not less than 3 atom% and not more than 20 atom% and **in that** an organic silicon compound film having the compositional ratio of oxygen of less than 20 atom% among silicon, oxygen and carbon is formed on a position opposed to the container surface across the barrier film, the organic silicon compound film being formed by a plasma CVD with an organic silicon compound gas and oxygen gas as raw materials.

2. The synthetic resin container possessing a higher barrier property according to claim 1, wherein the compositional ratio of carbon in the barrier film is not more than 8 atom%.

3. The synthetic resin container possessing a higher barrier property according to claim 1 or claim 2, wherein the barrier film has an angle of contact with water within a range of 40 deg to 60 deg.

**Patentansprüche**

1. Kunstharzbehälter mit höherem Sperrvermögen, **dadurch gekennzeichnet, dass** zumindest ein Sperrfilm an mindestens einer der Innen- und Außenflächen eines Behälterkörpers durch eine plasmaunterstützte chemische Gasabscheidung mit organischem Silizium und Sauerstoffgas als Ausgangsstoffe gebildet ist, wobei der Sperrfilm Siliziumoxid enthält, bei dem der Sauerstoff in dem Zusammensetzungsverhältnis von Silizium, Sauerstoff und Kohlenstoff nicht weniger als 50 Atomprozent beträgt und bei dem der Kohlenstoff in dem Zusammensetzungsverhältnis von Silizium, Sauerstoff und Kohlenstoff nicht weniger als 3 Atomprozent und nicht mehr als 20 Atomprozent beträgt, und dass an einer der Behälterfläche über den Sperrfilm gegenüberliegenden Position ein Film aus einer organischen Siliziumverbindung gebildet ist, bei der der Sauerstoff in dem Zusammensetzungsverhältnis von Silizium, Sauerstoff und Kohlenstoff weniger als 20% beträgt, wobei der Film aus organischem Silizium durch eine plasmaunterstütze chemische Gasabscheidung mit organischem Silizium und Sauerstoffgas als Ausgangsstoffe gebildet ist.

**2.** Kunstharzbehälter mit höherem Sperrvermögen gemäß Anspruch 1, wobei das Zusammensetzungsverhältnis von Kohlenstoff in dem Sperrfilm nicht mehr als 8 Atomprozent beträgt.

**3.** Kunstharzbehälter mit höherem Sperrvermögen gemäß Anspruch 1 oder Anspruch 2, wobei der Sperrfilm einen Kontaktwinkel mit Wasser in einem Bereich von 40 Grad bis 60 Grad hat.

## Revendications

**1.** Récipient en résine synthétique possédant une propriété de barrière supérieure, **caractérisé en ce qu'**au moins un film barrière est formé sur au moins l'une d'une surface intérieure et d'une surface extérieure d'un corps de récipient par un procédé de dépôt chimique en phase vapeur, CVD, par plasma avec un gaz de composé de silicium organique et un gaz d'oxygène en tant que matières premières, le film barrière contenant de l'oxyde de silicium dans lequel un taux de composition d'oxygène parmi le silicium, l'oxygène et le carbone n'est pas inférieur à 50 % atomiques et un taux de composition de carbone parmi le silicium, l'oxygène et le carbone n'est pas inférieur à 3 % atomiques et pas supérieur à 20 % atomiques, et **en ce qu'**un film de composé de silicium organique ayant le taux de composition d'oxygène inférieur à 20 % atomiques parmi le silicium, l'oxygène et le carbone est formé à une position opposée à la surface de récipient par rapport au film barrière, le film de composé de silicium organique étant formé par un CVD par plasma avec un gaz de composé de silicium organique et un gaz d'oxygène en tant que matières premières.

**2.** Récipient en résine synthétique possédant une propriété de barrière supérieure selon la revendication 1, dans lequel le taux de composition de carbone dans le film barrière n'est pas supérieur à 8 % atomiques.

**3.** Récipient en résine synthétique possédant une propriété de barrière supérieure selon la revendication 1 ou 2, dans lequel le film barrière a un angle de contact avec l'eau dans une plage de 40 degrés à 60 degrés.

# FIG. 1

FIG. 2

# FIG. 3

**EP 1 921 015 B1**

**Patent documents cited in the description**

- JP 2004168325 A

- WO 2004087989 A